# EUROPEAN PATENT APPLICATION

(11) **EP 4 174 943 A1**
(43) Date of publication of application: **03.05.2023**
(21) Application number: 22197488.4
(22) Date of filing: 23.09.2022
(51) Int. Cl.: H01L 25/075, H01L 33/00, H01L 33/62

(54) **ELECTRONIC DEVICE AND MANUFACTURING METHOD OF ELECTRONIC DEVICE**

(30) Priority: 29.10.2021 US 202163273153 P; 08.08.2022 CN 202210945833
(71) Applicant: InnoLux Corporation, Jhunan Town Miao li 35053 (TW)
(72) Inventor: CHEN, Yi-An, 35053 Jhunan Town, Miaoli County (TW); HSIEH, Tsau-Hua, 35053 Jhunan Town, Miaoli County (TW)
(74) Representative: Becker, Eberhard

(57) **Abstract**

Provided is an electronic device (10a, 10b, 10c, 10d, 10e, 10f, 10g, 10h, 10i, 10j, 10k, 20) including a first substrate (100) and a first light-blocking element (B1). The first substrate (100) includes a plurality of subpixels (SP). Each subpixel (SP) includes a first main pad (MP), a first redundant pad (RP), and a first light-emitting element (LEI). The first light-emitting element (LEI) is disposed on the first main pad (MP). The first light-blocking element (B1) overlaps the first redundant pad (RP) in a vertical direction (n) of the first substrate (100). A manufacturing method of the electronic device (10a, 10b, 10c, 10d, 10e, 10f, 10g, 10h, 10i, 10j, 10k, 20) is also provided.

## Description

### BACKGROUND

### Technical Field

The disclosure relates to an electronic device and a manufacturing method of the electronic device.

### Description of Related Art

As the technology advances, electronic devices have been introduced to various products, such as an electronic device with micro-LEDs. This electronic device includes main pads and redundant pads. While the main pads are for setting the micro-LEDs, the redundant pads are for repairing the defective micro-LEDs (for example, when defects are found in a micro-LED, a new micro-LED would be disposed on the redundant pads). However, the redundant pads before the repair are not provided with any micro-LEDs and would reflect light like ambient light, thereby reducing the ambient contrast ratio of the electronic device.

### SUMMARY

According to an embodiment of the disclosure, the electronic device includes: a first substrate including multiple sub-pixels, and a first light-blocking element. One of the sub-pixels includes a first main pad, a first redundant pad, and a first light-emitting element. The first light-emitting element is disposed on the first main pad. The first light-blocking element and the first redundant pad overlap in a vertical direction of the first substrate.

According to an embodiment of the disclosure, a manufacturing method of an electronic device includes the following steps. First, a first substrate is provided, and the first substrate includes multiple sub-pixels. One of the sub-pixels includes a first main pad and a first redundant pad. Next, the first light-emitting elements are transferred to the first main pad of the sub-pixels. Then, the first light-emitting elements are inspected. After that, at least one second light-emitting element is transferred to part of the first redundant pad. Next, the first light-blocking elements are disposed, such that the first light-blocking elements overlap another part of the first redundant pads in a vertical direction of the first substrate.

### BRIEF DESCRIPTION OF THE DRAWING

The drawings are included for further understanding of the disclosure, and the drawings are incorporated into this specification and constitute part of this specification. The drawings illustrate the embodiments of the disclosure, and together with the description, serve to explain the principles of the disclosure.
FIG. 1A to FIG. IE are schematic top views illustrating a partial fabrication process of an electronic device according to an embodiment.
FIG. 2 is a schematic cross-sectional view of a first embodiment according to the line A-A' in FIG. IE.
FIG. 3 is a partial top view of an electronic device according to an embodiment of the disclosure.
FIG. 4 is a schematic cross-sectional view of a second embodiment according to the line A-A' in FIG. IE.
FIG. 5 is a schematic cross-sectional view of a third embodiment according to the line A-A' in FIG. IE.
FIG. 6 is a schematic cross-sectional view of a fourth embodiment according to the line A-A' in FIG. IE.
FIG. 7 is a schematic cross-sectional view of a fifth embodiment according to the line A-A' in FIG. IE.
FIG. 8 is a schematic cross-sectional view of a sixth embodiment according to the line A-A' in FIG. IE.
FIG. 9 is a schematic cross-sectional view of a seventh embodiment according to the line A-A' in FIG. IE.
FIG. 10 is a schematic cross-sectional view of the first embodiment according to the line B-B' in FIG. 3.
FIG. 11 is a schematic cross-sectional view of the second embodiment according to the line B-B' in FIG. 3.
FIG. 12 is a schematic cross-sectional view of the third embodiment according to the line B-B' in FIG. 3.
FIG. 13 is a schematic top view of an electronic device according to an embodiment of the disclosure.

### DESCRIPTION OF THE EMBODIMENTS

The disclosure may be understood by referring to the following detailed description with reference to the drawings. For readers' convenience and the brevity of drawings, the drawings of this disclosure only depict part of an electronic device, and the specific elements in the drawings may not be drawn according to actual scale. In addition, the number and size of each element in the drawings are only for schematic purposes and do not limit the scope of the disclosure.

When a structure (a layer, an element, or a substrate) in this disclosure is described to be "on" another structure (a layer, an element, or a substrate), it may refer to the two structures being adjacent and connected directly to each other, or it may refer to two structures being adjacent but connected indirectly. Indirect connection indicates that there is at least one intermediary structure (an intermediary layer, or an intermediary element, etc.) between the two structures, in which the lower side surface of a structure is adjacent to or directly connected to the upper side surface of the intermediate structure, and the upper side surface of the other structure is adjacent to or directly connected to the lower side surface of the intermediate structure, and the intermediary structure may be composed of a single-layer or multi-layer entity structure or a non-entity structure, to which the disclosure is not limited. In the disclosure, when a certain structure is disposed "on" other structures, it may mean that a certain structure is "directly" on other structures, or it indicates that a certain structure is "indirectly" on other structures, that is, there is at least one structure sandwiched between a certain structure and other structures.

The electrical connection or coupling described in the disclosure may refer to direct connection or indirect connection. Direct connection indicates that terminals of the elements of two circuits are directly connected or are connected to each other by a conductive line, whereas indirect connection indicates that, between the terminals of the elements of two circuits, there is a combination of at least one element like switches, diodes, capacitors, inductors, or other non-conductive line segments and at least one conductive segment or resistor, or a combination of at least two of the elements mentioned above and at least one conductive segment or resistor.

In this disclosure, the thickness, length, and width may be measured by an optical microscopy and/or scanning electron microscopy (SEM), but it is not limited thereto. In addition, there may be a certain margin in any two values or directions used for comparison. If the first value is equal to the second value, it implies that there may be a margin of about 10% between the first value and the second value; if the first direction is perpendicular to the second direction, the angle between the first direction and the second direction may be between 80 degrees and 100 degrees; if the first direction is parallel to the second direction, the angle between the first direction and the second direction may be between 0 degrees and 10 degrees.

Terms such as "about," "approximately," "substantially," and "generally" in the text usually mean it is within 10%, 5%, 3%, or 2%, 1%, or 0.5% of a given value or range.

Reference will now be made in detail to the exemplary embodiments of the disclosure, examples of which are illustrated in the accompanying drawings. Wherever possible, the same reference numerals are used in the drawings and description to refer to the same or like parts.

In the following embodiments, features in several different embodiments may be replaced, recombined, and mixed to create other embodiments without departing from the spirit of the disclosure. As long as the features of the various embodiments do not violate the spirit of the disclosure or conflict with each other, they may be mixed and matched at will.

In the disclosure, the electronic device includes a display device, a touch display device, a light-emitting device, an antenna device, a sensing device, a splicing device, or any suitable electronic device, but the disclosure is not limited thereto.

The electronic device includes a light-emitting diode (LEDs), such as organic light-emitting diodes (OLED), micro-LED or mini-LED, a material of quantum dots (QDs), quantum dot light-emitting diodes (QLED or QDLED), fluorescent materials, phosphor materials, other suitable materials, or a combination thereof, but the disclosure is not limited thereto.

In addition, the electronic device may be a color display device or a monochrome display device, and the shape of the electronic device may be rectangular, circular, polygonal, a shape with curved edges, or other suitable shapes. In the disclosure, the electronic device is exemplified as a color electronic device in the shape of a rectangle, but the disclosure is not limited thereto.

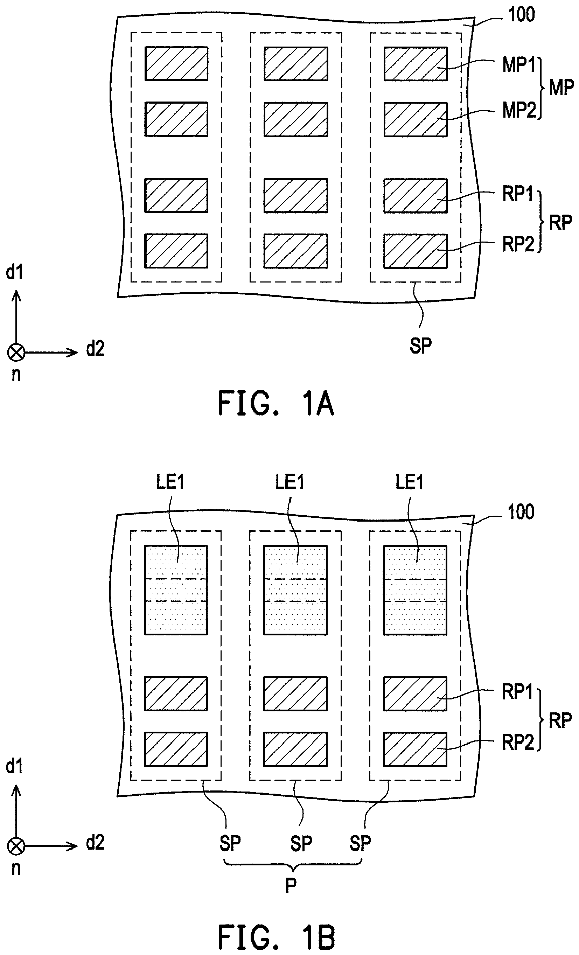

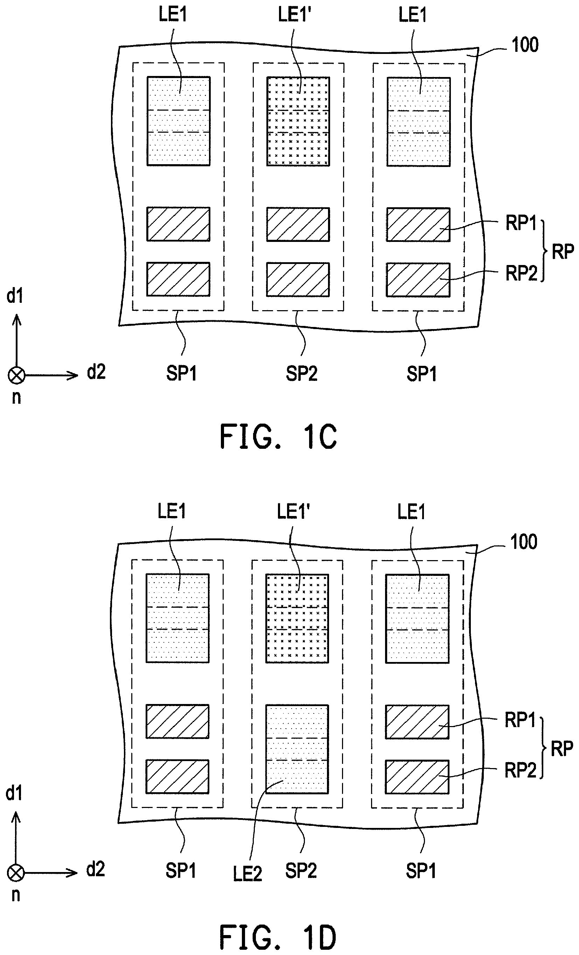

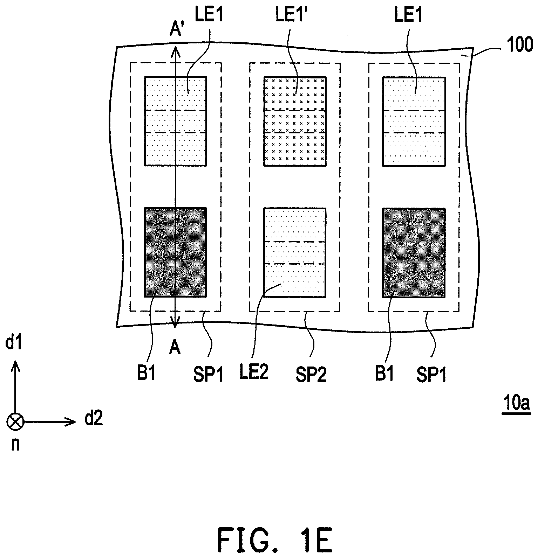

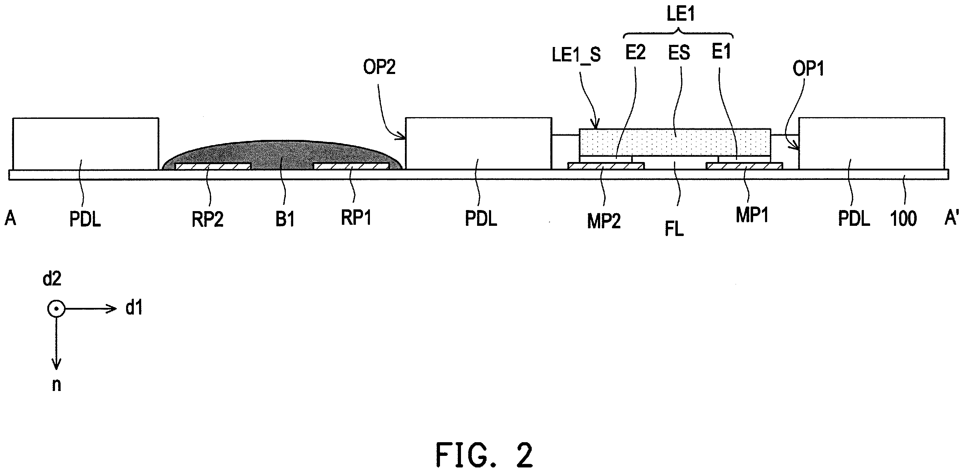

FIG. 1A to FIG. IE are schematic top views of a partial manufacturing process of an electronic device according to an embodiment, and FIG. 2 is a schematic cross-sectional view of the first embodiment according to the line A-A' in FIG. IE. This flowchart only serves as an example, and is not intended to limit the steps of manufacturing the electronic device.

As shown in FIG. 1A to FIG. IE and FIG. 2, the embodiment provides a manufacturing method of an electronic device 10a

First, in FIG. 1A, a substrate 100 is provided, and the substrate 100 includes a plurality of sub-pixels SP, and the sub-pixels SP form a pixel P. In some embodiments, the substrate 100 is a circuit substrate. The circuit substrate may, for example, include a substrate and active components, passive components, signal lines, or other suitable electronic components disposed on the substrate. The material of the substrate includes, for example, glass, plastic, or a combination thereof, and the signal lines are, for example, a combination of scan lines, data lines, and power lines, but the disclosure is not limited thereto. The sub-pixels SP of the substrate 100 are, for example, arranged in an array, interleaved with one another (e.g., the pentile layout), or in other configuration, to which the disclosure is not limited. In this embodiment, one of the sub-pixels SP includes a main pad MP and a redundant pad RP. The main pad MP and the redundant pad RP include, for example, metal, metal oxide, or other suitable conductive materials, so as to be electrically connected to the substrate 100 (a circuit substrate) respectively. The main pad MP includes, for example, two pad patterns MP1 and MP2 that are separated from each other, and the redundant pad RP also includes, for example, two pad patterns RP1 and RP2 that are separated from each other. In some embodiments, the pad patterns MP1 and the pad patterns MP2 are disposed along a first direction d1, and the pad patterns RP1 and the pad patterns RP2 are also disposed along the first direction d1. In some embodiments, the main pad MP and the redundant pad RP in one sub-pixel SP are disposed along the first direction d1, but the disclosure is not limited thereto.

Next, as shown in FIG. 1B, the light-emitting elements LEI are transferred to the main pad MP of the sub-pixels SP. In some embodiments, the light-emitting elements LEI may be disposed on the main pad MP by mass transfer, but the disclosure is not limited thereto. For example, the light-emitting elements LEI are disposed along a second direction d2, and the second direction d2 is orthogonal to the first direction d1, but the disclosure is not limited thereto. The light-emitting elements LEI may, for example, emit light of various suitable colors (e.g., blue light) or UV light, but the disclosure is not limited thereto. In some embodiments, the light-emitting element LEI includes a self-luminous material. For example, in this embodiment, the light-emitting element LEI may be a light-emitting diode (LED), including materials like organic light-emitting diode (OLED), micro-LED, mini-LED, or QDs (QLED or QDLED, for example), fluorescence, phosphor, or other suitable materials, and the materials may be arranged and combined at will, and the disclosure is not limited thereto.

In some embodiments, one sub-pixel SP includes one light-emitting element LEI, three sub-pixels SP form one pixel P, and the light-emitting elements LEI in the three sub-pixels SP respectively emit light of different colors, such as red, green, and blue light, but the disclosure is not limited thereto. In other embodiments, the number of sub-pixels SP and/or light-emitting elements LEI in each pixel P and their corresponding color emission may be adjusted according to the actual design.

Next, in FIG. 1C, the light-emitting elements LEI are inspected. In some embodiments, visual inspection and/or electrical inspection may be performed on the light-emitting element LEI in the sub-pixel SP to inspect whether the sub-pixel SP has a defective pixel. This may be done, for example, by using automated optical inspection (AOI) to perform an appearance inspection on the light-emitting elements LEI to observe whether the light-emitting elements LEI have appearance defects, such as damage, scratches, and offsets; alternatively, an Open/Short test (O/S test) may perform, for example; an electrical inspection on the light-emitting elements LEI to check the light quality of the light-emitting elements LEI. In this embodiment, when a light-emitting element LEI in at least one sub-pixel SP is found to have a defect, it may be marked as a defective light-emitting element LE1'. It should be noted that the sub-pixel SP includes a sub-pixel SP1 and a sub-pixel SP2. In the embodiment, the sub-pixel SP1 is defined to include the light-emitting element LEI that function normally, and the sub-pixel SP2 is defined to include the defective light-emitting element LEI'.

Then, as shown in FIG. ID, at least one light-emitting element LE2 is transferred to part of the redundant pads RP. In some embodiments, when the light-emitting element LEI in at least one sub-pixel SP is found to have a defect, the light-emitting element LE2 may also be disposed on the redundant pad RP in the sub-pixels SP by, but not limited to, mass transfer for repair, and the light-emitting element LE2 is adjacent to the defective light-emitting element LEI' in the first direction d1. Note that the light-emitting element LEI' may be defective due to situations such as the defective light emission of the light-emitting element LEI' itself, a defective main pad MP, or poor electrical connection between the light-emitting element LEI and the main pad MP, to which the disclosure is not limited.

Next, in FIG. IE, a plurality of light-blocking elements B1 are disposed to overlap another part of the redundant pads RP in the vertical direction n of the substrate 100. After at least one light-emitting element LE2 is transferred to part of the redundant pads RP, the light-blocking elements B1 are disposed onto the redundant pads RP that are not provided with the light-emitting element LE2. In some embodiments, the light-blocking element B1 is in contact with the redundant pad RP. In this embodiment, the light-blocking elements B1 are disposed by using, but not limited to, automatic optical inspection and inkjet technology. For example, the substrate 100 is photographed by an automatic optical inspection device (not shown), or an suitable optical inspection procedure may be performed, to obtain one or more images, and these images are then recognized and marked or classified, thereby obtaining the positions of the redundant pads RP that are not provided with the light-emitting element LE2. Next, an inkjet process is performed on the substrate 100 by using an inkjet printing device (not shown), so as to set the light-blocking element B1 on the position where the redundant pad RP of the light-emitting element LE2 is not provided, and the light-blocking element B 1 covers, for example, the redundant pad RP. In some embodiments, the surface of the light-blocking element B1 (the surface away from the substrate 100) formed by the inkjet process has, for example, a circular arc shape, but the disclosure is not limited thereto. The light-blocking element B1 is, for example, a black light-blocking layer, and the material of the light-blocking element B1 includes, for example, a photocurable material, a thermally cured material, or a combination thereof. In this embodiment, the material of the light-blocking element B1 includes, but is not limited to, matte black ink, such that it appears matte black when viewed by the user to reduce the light reflected by the redundant pad RP not provided with the light-emitting element LE2, such that the electronic device 10a has a high ambient contrast ratio. It is worth noting that, after the light-blocking elements B1 are provided, the light-emitting element LE2 may be subjected to the appearance inspection and/or the electrical inspection by, for example, using an open-circuit and short-circuit test, but this disclosure is not limited thereto.

In some embodiments, the light-emitting element LEI has, for example, a first electrode E1, a second electrode E2, and an epitaxial layer ES, as shown in FIG. 2. The surface LE1_S of the epitaxial layer ES away from the substrate 100 defines, for example, the light-emitting surface of the light-emitting element LEI, and the first electrode E1 and the second electrode E2 may be disposed, for example, on the surface opposite to the surface LE1_S of the epitaxial layer ES to be electrically connected respectively to the pad pattern MP1 and the pad pattern MP2 of the main pad MP. In this embodiment, the light-emitting element LEI includes a flip-chip micro-LED, but the disclosure is not limited thereto. In other embodiments, the light-emitting element LEI includes a vertical micro-LED or a horizontal micro-LED. The light-emitting element LE2 is, for example, the same as or similar to the light-emitting element LEI, and therefore details thereof are not described again.

In some embodiments, a pixel definition layer PDL is disposed on the substrate 100, as shown in FIG. 2. The pixel definition layer PDL defines, for example, a plurality of openings OP1 for setting the light-emitting element LEI and a plurality of openings OP2 for the pad pattern RP1 and the pad pattern RP2. The light-blocking layer B1 covers and/or contacts the pad pattern RP1 and the pad pattern RP2. The material of the pixel definition layer PDL includes, for example, organic materials, but the disclosure is not limited thereto. In some embodiments, the material of the pixel definition layer PDL has photosensitive properties, which may be formed by a patterning process. Additionally, in some embodiments, the pixel definition layer PDL has, for example, hydrophobicity.

In some embodiments, the substrate 100 is provided with a filling layer FL, as shown in FIG. 2. The filling layer FL is disposed, for example, in the opening OP1 defined by the pixel definition layer PDL and is adjacent to or surrounding the light-emitting element LEI. The filling layer FL may be used, for example, to fix or protect the light-emitting element LEI. In some embodiments, the maximum distance between the upper surface (the surface away from the substrate 100) of the filling layer FL and the substrate 100 in the vertical direction n may be, for example, smaller than the maximum distance between the surface LE1_S (the surface away from the substrate 100) of the light-emitting element LE1 and the substrate 100 in the vertical direction n, as shown in FIG. 2, but the disclosure is not limited thereto. In other embodiments, the maximum distance between the filling layer FL and the substrate 100 may be, for example, greater than or equal to the maximum distance between the surface LE1_S of the light-emitting element LEI and the substrate 100. In some embodiments, the filling layer FL includes a transparent material, a non-transparent material, or a combination thereof, and has a light-blocking characteristic. For example, the material of the filling layer FL includes epoxy resin, acrylic, other suitable materials, or a combination thereof.

Although the manufacturing method of the electronic device 10a of the embodiment is described using the above process as an example, the manufacturing method of the electronic device 10a of the disclosure is not limited thereto. The above steps may be deleted or added with other steps as needed. The above steps may also be adjusted in order according to requirements.

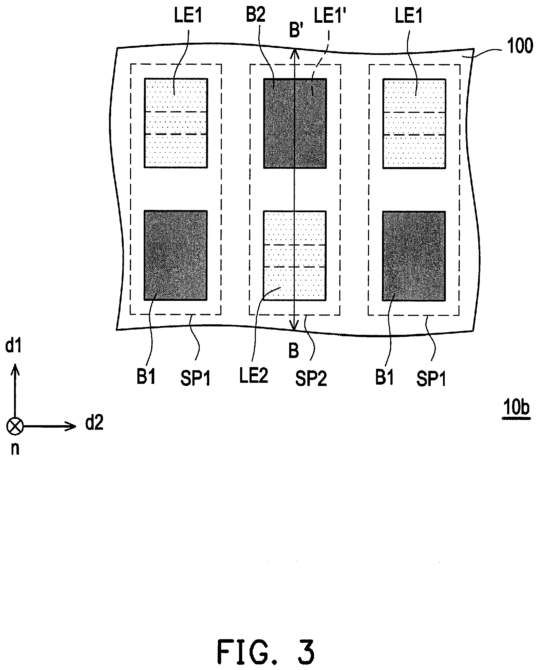

FIG. 3 is a partial top view of an electronic device according to an embodiment of the disclosure. The embodiment of FIG. 3 may adopt the reference numbers and part of the content of the embodiment of FIG. IE. As the same or similar numbers refer to the same or similar elements, the description of the same technical content is omitted hereinafter.

As shown in FIG. 3, the main difference between the electronic device 10b of this embodiment and the electronic device 10a is that the electronic device 10b further includes at least one light-blocking element B2. In addition to providing the light-blocking elements B1, at least one light-blocking element B2 is also disposed, such that the light-blocking element B2 and the defective light-emitting element LEI' overlap in the vertical direction n of the substrate 100 to reduce the light that may be reflected by the defective light-emitting element LEI', such that the electronic device lOb has a high ambient contrast ratio. As the materials of the light-blocking element B2 and the light-blocking element B1 and the forming techniques thereof may be the same or similar, the same is not repeated herein.

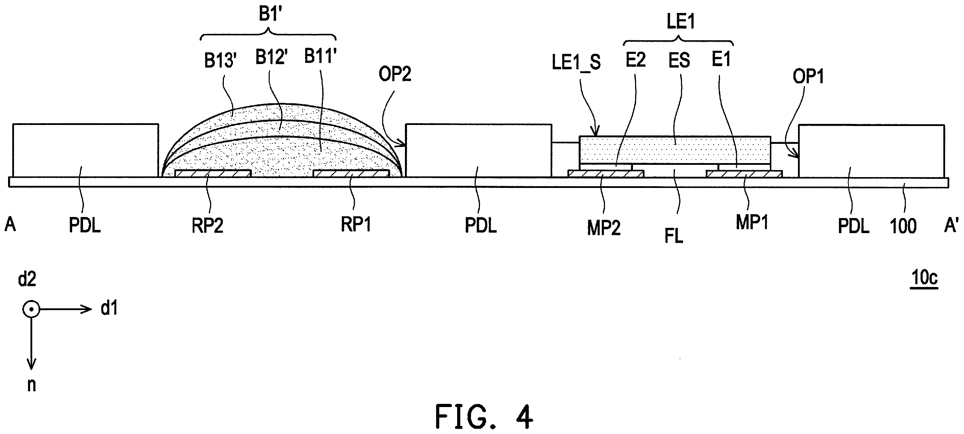

FIG. 4 is a schematic cross-sectional view of the second embodiment according to the line A-A' in FIG. IE. The embodiment of FIG. 4 may adopt the reference numbers and part of the content of the embodiment of FIG. 2. As the same or similar numbers refer to the same or similar elements, the description of the same technical content is omitted hereinafter.

As shown in FIG. 4, the main difference between the electronic device 10c of this embodiment and the electronic device 10a is that the light-blocking element B1' is a combination of at least two of a red filter layer, a green filter layer, and a blue filter layer. The light-blocking element B1' may include a stack structure with at least two of the red filter layer, the green filter layer, and the blue filter layer, such that the light-blocking element B1' is able to have the effect of the light-blocking element B1. In other words, the electronic device 10c of this embodiment also has a display screen with high ambient contrast ratio, high light extraction efficiency, and/or wide color gamut. Although FIG. 4 shows that the light-blocking element B1' is a three-layer stack structure with the red filter layer B11', the green filter layer B12' and the blue filter layer B13', and that the red filter layer B11' is in contact with the pad pattern RP1 and the pad pattern RP2, the disclosure is not limited thereto.

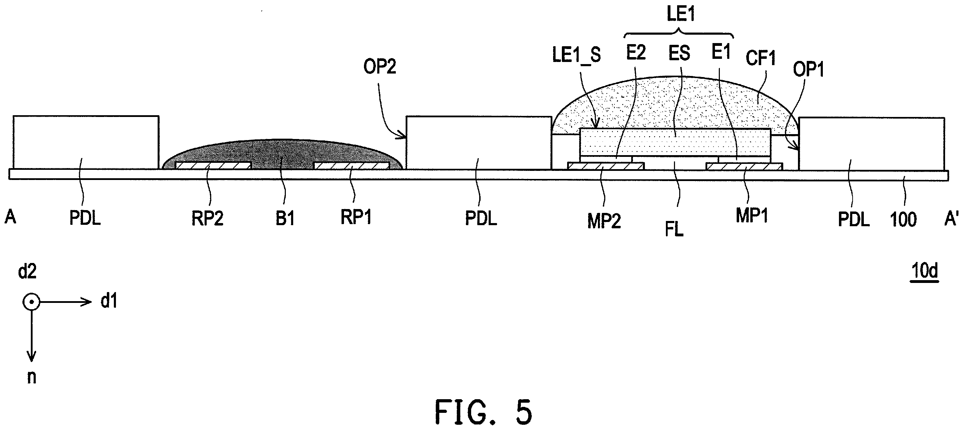

FIG. 5 is a schematic cross-sectional view of the third embodiment according to the line A-A' in FIG. IE. The embodiment of FIG. 5 may adopt the reference numbers and part of the content of the embodiment of FIG. 2. As the same or similar numbers refer to the same or similar elements, the description of the same technical content is omitted hereinafter.

As shown in FIG. 5, the main difference between the electronic device 10d of this embodiment and the electronic device 10a is that the electronic device 10d includes a color filter layer CF1. The color filter layer CF1 is specifically disposed on the surface LE1_S (i.e., the light-emitting surface of the light-emitting element LEI), and the substrate 100 at least partially overlaps the light-emitting element LEI in the vertical direction n, and the color of the light emitted by the light-emitting element LEI may be adjusted or converted thereby. The color filter layer CF1 includes, for example, a red filter layer, a green filter layer, a blue filter layer, or other suitable color filter layers, but the disclosure is not limited thereto. For example, the light-emitting element LEI emits blue light, and the color filter layer CF1 is a green filter layer, but the disclosure is not limited thereto.

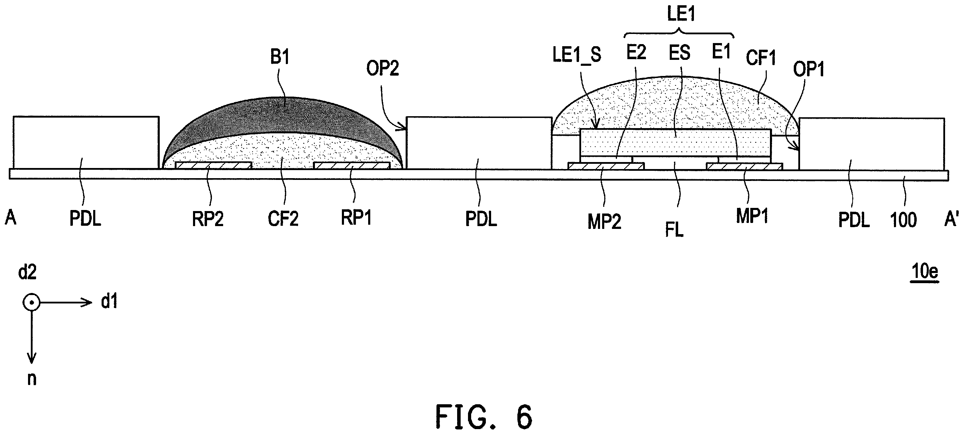

FIG. 6 is a schematic cross-sectional view of the fourth embodiment according to the line A-A' in FIG. IE. The embodiment of FIG. 6 may adopt the reference numbers and part of the content of the embodiment of FIG. 5. As the same or similar numbers refer to the same or similar elements, the description of the same technical content is omitted hereinafter.

As shown in FIG. 6, the main difference between the electronic device 10e of this embodiment and the electronic device 10d is that the electronic device 10e includes a color filter layer CF2, and the color filter layer CF2 is disposed between the redundant pad RP and the light-blocking element B1. Before performing the step of disposing the light-blocking elements B1, the color filter layer CF2 and the color filter layer CF1 may be formed in the same process, such that the color filter layer CF2 is disposed in the opening OP2 defined by the pixel definition layer PDL. Therefore, the color filter layer CF2 may, for example, at least partially cover and/or contact the redundant pad RP in the opening OP2. After the light-blocking elements B1 are formed, the light-blocking elements B1 disposed in the openings OP2 overlap, for example, the color filter layer CF2 in the vertical direction n of the substrate 100.

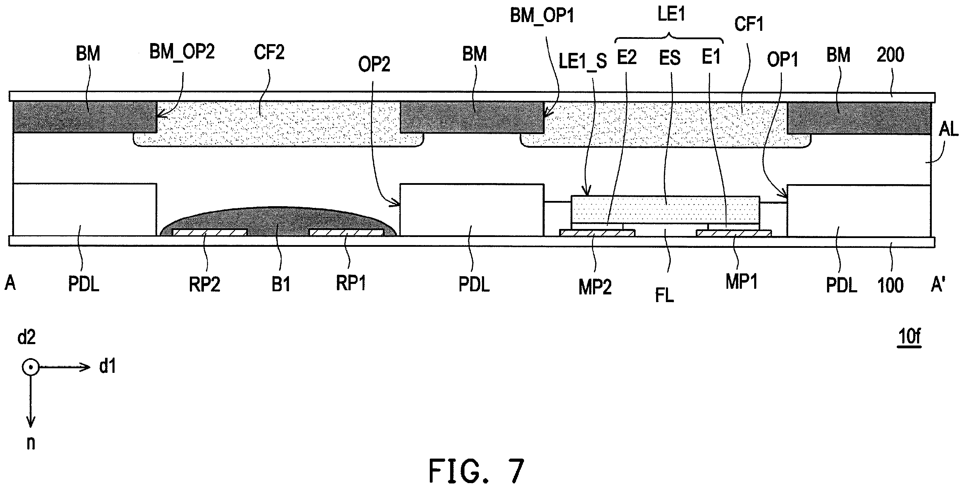

FIG. 7 is a schematic cross-sectional view of the fifth embodiment according to the line A-A' in FIG. IE. The embodiment of FIG. 7 may adopt the reference numbers and part of the content of the embodiment of FIG. 2. As the same or similar numbers refer to the same or similar elements, the description of the same technical content is omitted hereinafter.

As shown in FIG. 7, the main difference between the electronic device 10f of this embodiment and the electronic device 10a is that the electronic device 10f further includes an opposite substrate 200. In this embodiment, the opposite substrate 200 is disposed opposite to the substrate 100. In some embodiments, a light-blocking pattern layer BM and the color filter layers CF1 and CF2 are disposed on the surface of the opposite substrate 200 facing the substrate 100. The light-blocking pattern layer BM is adjacent to or surrounds the color filter layers CF1 and CF2, for example. In some embodiments, the light-blocking pattern layer BM has a plurality of openings BM_OP1 and BM_OP2 to form a grid structure, but the disclosure is not limited thereto. The material of the light-blocking pattern layer BM includes, for example, black resin, black photoresist, metal, or a combination thereof, which is not limited in the disclosure. In some embodiments, the color filter layer CF1 and the color filter layer CF2 are respectively disposed in the openings BM_OP1 and BM_OP2 of the light-blocking pattern layer BM. In some embodiments, the openings BM_OP1 and BM_OP2 of the light-blocking pattern layer BM at least partially and respectively overlap the openings OP1 and OP2 defined by the pixel definition layer PDL in the vertical direction n of the substrate 100. In addition, in this embodiment, an adhesive layer AL is further provided between the substrate 100 and the opposite substrate 200. The material of the adhesive layer AL includes optical clear resin (OCR) or optical clear adhesive (OCA), such as acrylic resin, silicone resin, epoxy resin, other suitable materials, or a combination thereof, but the disclosure is not limited thereto. In some embodiments, in addition to the function of adhering the substrate 100 and the opposite substrate 200 to each other, the adhesive layer AL may also have water and oxygen blocking properties, protection properties, or other properties, but the disclosure is not limited thereto.

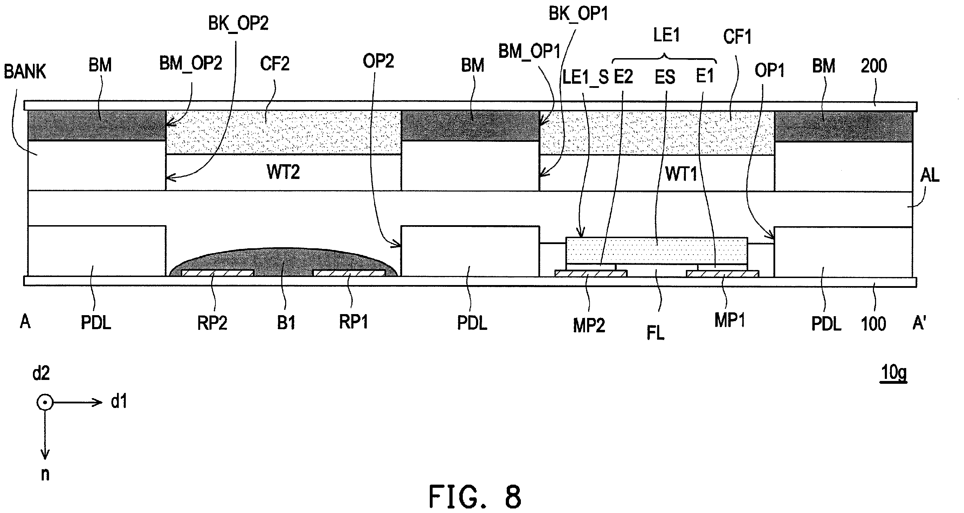

FIG. 8 is a schematic cross-sectional view of the sixth embodiment according to the line A-A' in FIG. IE. The embodiment of FIG. 8 may adopt the reference numbers and part of the content of the embodiment of FIG. 7. As the same or similar numbers refer to the same or similar elements, the description of the same technical content is omitted hereinafter.

As shown in FIG. 8, the main difference between the electronic device 10g of this embodiment and the electronic device 10f is that the electronic device lOg further includes a wavelength conversion layer WT1, a wavelength conversion layer WT2, and a barrier layer BANK. Similar to the light-blocking pattern layer BM, the barrier layer BANK has multiple openings, such as openings BK_OP1 and BK_OP2. And the openings BK_OP1 and BK_OP2 of the barrier layer BANK may respectively correspond to the openings BM_OP1 and BM_OP2 of the light-blocking pattern layer BM. The wavelength conversion layer WT1 is provided, for example, between the color filter layer CF1 and the light-emitting element LEI. In this embodiment, the wavelength conversion layer WT1 is disposed in the opening BK_OP1 of the barrier layer BANK, the color filter layer CF1 is disposed between the wavelength conversion layer WT1 and the opposite substrate 200, and the wavelength conversion layer WT1 overlaps the color filter layer CF1 in the vertical direction n of the substrate 100. In some embodiments, the material of the wavelength converting layer WT1 includes quantum dot materials, phosphor materials, fluorescent materials, other suitable wavelength converting materials, or a combination thereof. In other words, the wavelength conversion layer WT1 may convert the light emitted from the light-emitting element LEI into light having another wavelength. In some embodiments, the wavelength range converted by the wavelength conversion layer WT may approximately correspond to the color of the color filter layer CF1. For example, in the vertical direction n of the substrate 100, the red wavelength conversion layer overlaps the red filter layer can overlap, the green wavelength conversion layer overlaps the green filter layer, and the blue wavelength conversion layer overlaps the blue filter layer, but the disclosure is not limited thereto. The wavelength conversion layer WT2 is, for example, disposed in the opening BK_OP2 of the barrier layer BANK, and the color filter layer CF2 is disposed between the wavelength conversion layer WT2 and the opposite substrate 200. The wavelength conversion layer WT2 overlaps the color filter layer CF2 in the vertical direction n of the substrate 100. The wavelength conversion layer WT2 may be, for example, the same as or similar to the wavelength conversion layer WT1, and thus details are not repeated hereinafter. It should be noted that, it is also possible to not provide a wavelength conversion layer WT2 in other embodiments.

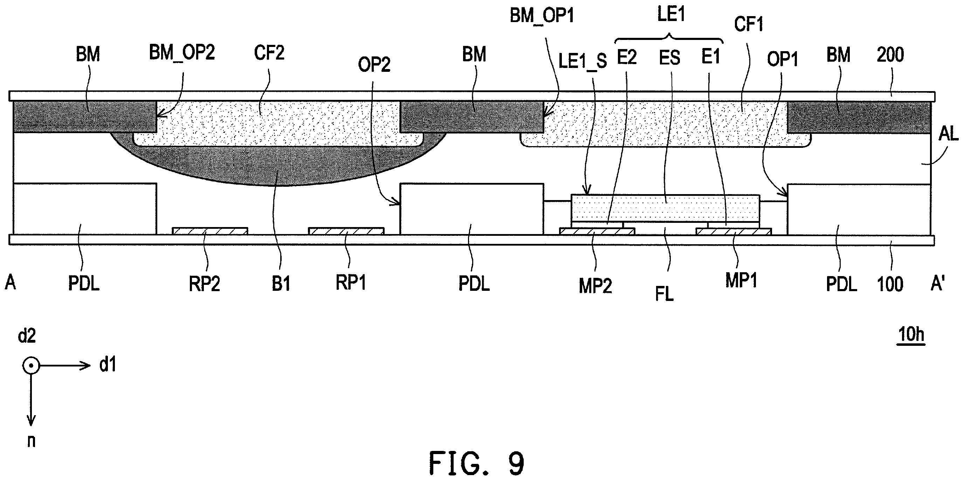

FIG. 9 is a schematic cross-sectional view of the seventh embodiment according to the line A-A' in FIG. IE. The embodiment of FIG. 9 may adopt the reference numbers and part of the content of the embodiment of FIG. 7. As the same or similar numbers refer to the same or similar elements, the description of the same technical content is omitted hereinafter.

As shown in FIG. 9, the main difference between the electronic device 10h of this embodiment and the electronic device 10f is that the light-blocking element B1 is disposed on the opposite substrate 200. The light-blocking element B1 is disposed, for example, between the adhesive layer AL and the opposite substrate 200, and at least overlaps the redundant pad RP that is not provided with the light-emitting element in the vertical direction n of the substrate 100. As shown in FIG. 9, the light-blocking element B1 may be partially in contact with the color filter layer CF2 and/or the light-blocking pattern layer BM, but the disclosure is not limited thereto.

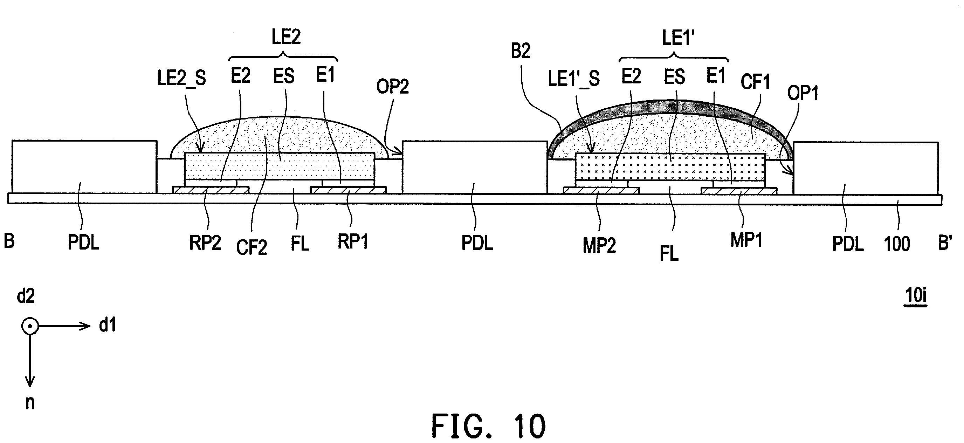

FIG. 10 is a schematic cross-sectional view of the first embodiment according to the line B-B' in FIG. 3.

As shown in FIG. 10, in the electronic device 10i of the embodiment, a defective light-emitting element LEI' of the sub-pixel SP2 is disposed on the main pad MP, and the normal light-emitting element LE2 is disposed on the redundant pad RP. As described in the foregoing embodiments, when it is found that the light-emitting element LEI in at least one sub-pixel SP has a defect, the light-emitting element LE2 is transferred to the sub-pixels SP, and the light-emitting element LE2 is adjacent to the defective light-emitting element LEI' in the first direction d1. In this embodiment, the color filter layer CF1 and the color filter layer CF2 are respectively formed on the surface LE1'_S of the defective light-emitting element LE1' and the surface LE2_S of the light-emitting element LE2, and the light-blocking element B2 covers and/or contacts the color filter layer CF1 and overlaps the defective light-emitting element LEI' in the vertical direction n of the substrate 100. From another perspective, the color filter layer CF1 is disposed between the light-blocking element B2 and the defective light-emitting element LE1'.

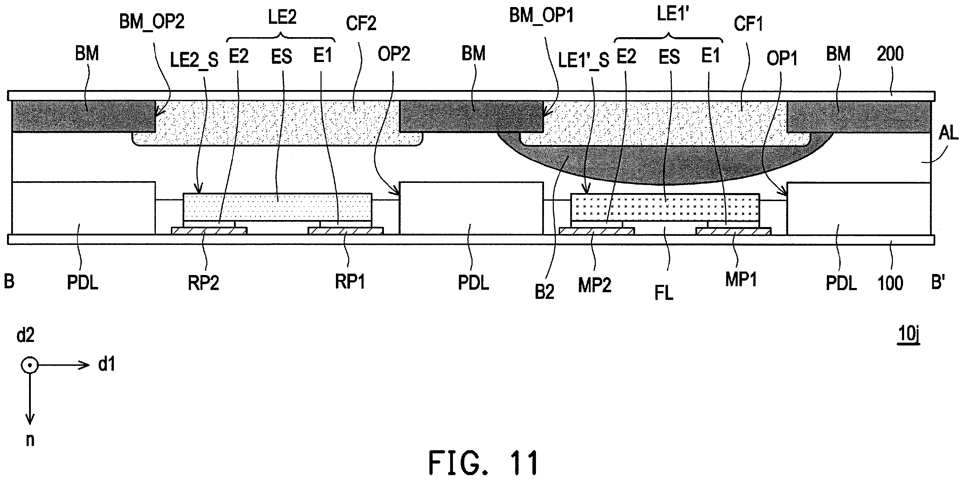

FIG. 11 is a schematic cross-sectional view of the second embodiment according to the line B-B' in FIG. 3. The embodiment of FIG. 11 may adopt the reference numbers and part of the content of the embodiments of FIG. 7 and FIG. 10. As the same or similar numbers refer to the same or similar elements, the description of the same technical content is omitted hereinafter.

As shown in FIG. 11, the main difference between the electronic device 10j of this embodiment and the electronic device 10i is that the electronic device 10j further includes an opposite substrate 200, and the color filter layers CF1 and CF2 and the light-blocking element B2 are disposed on the opposite substrate 200. In this embodiment, the opposite substrate 200 is disposed opposite to the substrate 100. In some embodiments, the light-blocking pattern layer BM and the color filter layers CF1 and CF2 are disposed on the surface of the opposite substrate 200 facing the substrate 100. The light-blocking element B2 is, for example, disposed between the opposite substrate 200 and the defective light-emitting element LE1', and the light-blocking element B2 contacts the color filter layer CF1 and overlaps the defective light-emitting element LEI' in the vertical direction n of the substrate 100. In addition, in this embodiment, an adhesive layer AL is further provided between the substrate 100 and the opposite substrate 200.

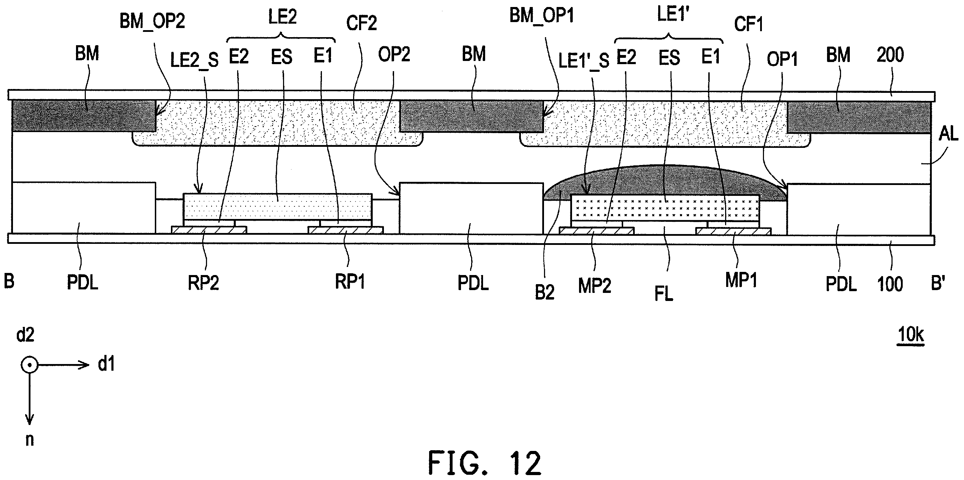

FIG. 12 is a schematic cross-sectional view of the third embodiment according to the line B-B' in FIG. 3. The embodiment of FIG. 12 may adopt the reference numbers and part of the content of the embodiment of FIG. 11. As the same or similar numbers refer to the same or similar elements, the description of the same technical content is omitted hereinafter.

As shown in FIG. 12, the main difference between the electronic device 10k of this embodiment and the electronic device 10j is that the light-blocking element B2 is disposed on the substrate 100. The light-blocking element B2 contacts the surface LE1'_S of the defective light-emitting element LEI' and overlaps the defective light-emitting element LEI' in the vertical direction n of the substrate 100.

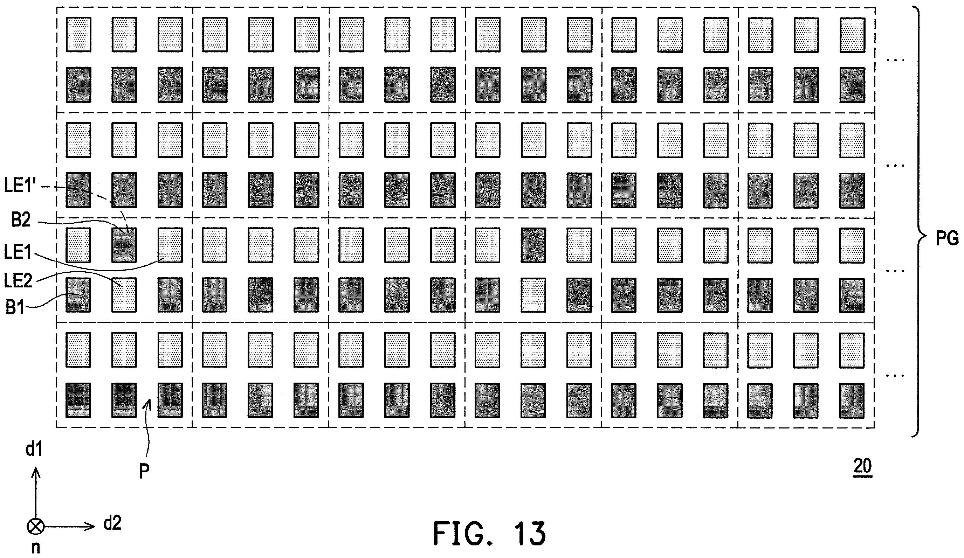

FIG. 13 is a schematic top view of an electronic device according to an embodiment of the disclosure.

As shown in FIG. 13, the electronic device 20 includes a pixel group PG, and the pixel group PG includes a plurality of pixels P disposed in an array, but the arrangement of the pixels P is not limited to what is shown in FIG. 13. In this embodiment, most (e.g., more than or equal to 90% of the total number of pixels P) of the light-emitting elements in the pixels P of the pixel group PG operate normally (the light-emitting element LEI). Also, in this embodiment, at least one light-emitting element in the pixels P of a small part (e.g., less than or equal to 10% of the total number of pixels P) of the pixel group PG is found defective (the defective light-emitting element LE1'), and the pixels P are therefore provided with the light-emitting element LE2 to replace the defective light-emitting elements LE1'. However, the light-emitting elements LEI and LE2 in the pixels P are interleaved in the second direction d2.

According to the above, in some embodiments of the disclosure, as the electronic device includes the light-blocking element B1 that overlaps the redundant pad and/or the light-blocking element B2 that overlaps the defective light-emitting element LE1' in the vertical direction of the substrate, the light reflected by the redundant pads and/or the defective light-emitting element LE1' may be reduced, such that the electronic device has a high ambient contrast ratio. In other embodiments of the disclosure, materials with high reflectivity and/or low transmittance may be selected as or added to the material of the light-blocking element, such that the electronic device can have a display screen with high light extraction efficiency and/or wide color gamut. In still other embodiments of the disclosure, the light-blocking element may overlap the defective light-emitting element in the vertical direction of the substrate to achieve the effects mentioned above.

## Claims

1. An electronic device (10a, 10b, 10c, 10d, 10e, 10f, 10g, 10h, 10i, 10j, 10k, 20), comprising:
a first substrate (100) comprising a plurality of sub-pixels (SP1, SP2), wherein one (SP1) of the sub-pixels (SP1, SP2) comprises:
a first main pad (MP);
a first redundant pad (RP); and
a first light-emitting element (LE1) disposed on the first main pad (MP); and
a first light-blocking element (B1) overlapping the first redundant pad (RP) in a vertical direction (n) of the first substrate (100).

2. The electronic device according to claim 1, wherein the first light-blocking element (B1) is disposed on the first substrate (100).

3. The electronic device according to claim 1, wherein the first light-blocking element (B1) is in contact with the first redundant pad (RP).

4. The electronic device according to claim 1, further comprising a second substrate (200) disposed opposite to the first substrate (100).

5. The electronic device according to claim 4, wherein the second substrate (200) comprises a color filter layer (CF1, CF2).

6. The electronic device according to claim 5, further comprising a wavelength conversion layer (WT1, WT2), wherein the wavelength conversion layer (WT1, WT2) is disposed between the color filter layer (CF1, CF2) and the first light-emitting element (LE1).

7. The electronic device according to claim 4, wherein the first light-blocking element (B1) is disposed on the second substrate (200).

8. The electronic device according to claim 1, wherein an other one (SP2) of the sub-pixels (SP1, SP2) comprises:
a second main pad (MP);
a second redundant pad (RP);
a second light-emitting element (LE2) disposed on the second redundant pad (RP); and
a third light-emitting element (LEI') disposed on the second main pad (MP), wherein the third light-emitting element (LEI') is defective.

9. The electronic device according to claim 8, further comprising a second light-blocking element (B2), wherein the second light-blocking element (B2) and the third light-emitting element (LE1') overlap in the vertical direction (n) of the first substrate (100).

10. A manufacturing method of an electronic device (10a, 10b, 10c, 10d, 10e, 10f, 10g, 10h, 10i, 10j, 10k, 20), comprising:
providing a first substrate (100), wherein the first substrate (100) comprises a plurality of sub-pixels (SP), and one of the sub-pixels (SP) comprises:
a first main pad (MP); and
a first redundant pad (RP);
transferring a plurality of first light-emitting elements (LEI, LEI') to the first main pad (MP) of the sub-pixels (SP);
inspecting the first light-emitting elements (LEI, LE1');
transferring at least one second light-emitting element (LE2) to part of the first redundant pad (RP); and
disposing a plurality of first light-blocking elements (B1), such that the first light-blocking elements (B1) overlap another part of the first redundant pad (RP) in a vertical direction (n) of the first substrate (100).

11. The manufacturing method of the electronic device according to claim 10, wherein the first light-blocking elements (B1) are disposed on the first substrate (100).

12. The manufacturing method of the electronic device according to claim 10, further comprising providing a second substrate (200), wherein the second substrate (200) is disposed opposite to the first substrate (100), and the first light-blocking elements (B1) are disposed on the second substrate (200).

13. The manufacturing method of the electronic device according to claim 10, wherein the second light-emitting element (LE2) is adjacent to a defective first light-emitting element (LEI') of the first light-emitting elements (LEI, LE1').

14. The manufacturing method of the electronic device according to claim 13, further comprising disposing a second light-blocking element (B2), such that the second light-blocking element (B2) overlap the defective first light-emitting element (LE1') in the vertical direction (n) of the first substrate (100).

15. The manufacturing method of the electronic device according to claim 14, further comprising providing a second substrate (200), wherein the second substrate (200) is disposed opposite to the first substrate (100), and the second light-blocking element (B2) is disposed between the second substrate (200) and the defective first light-emitting element (LE1').
